# EUROPEAN PATENT APPLICATION

(11) **EP 1 505 438 A2**
(43) Date of publication of application: **09.02.2005**
(21) Application number: 04017540.8
(22) Date of filing: 23.07.2004
(51) Int. Cl.: G03F 1/16, G03F 7/20, H01J 37/317

(54) **Stencil mask, charged particle irradiation apparatus and the method**

(30) Priority: 24.07.2003 JP 2003279324
(71) Applicant: SONY CORPORATION, Tokyo (JP); Kabushiki Kaisha Toshiba, Tokyo 105-8001 (JP); Ulvac, Inc., Chigasaki-shi, Kanagawa (JP)
(72) Inventor: Tomoyuki, Osada, Shinagawa-ku Tokyo (JP); Shibata, Takeshi, Minato-ku Tokyo (JP); Nishihashi, Tsutomu, Chigasaki-shi Kangawa (JP)
(74) Representative: Müller - Hoffmann & Partner

(57) **Abstract**

A stencil mask capable of attaining long durability without any special processing thereon, wherein an inversion means for inverting the front and back of the stencil mask formed with an opening pattern penetrating in the thickness direction is provided, so that positions can be changed, that is, a surface irradiated with charged particles can be on the side of facing to a substrate subjected to processing, and a surface faced to the substrate can be on the side of receiving irradiation of charged particles, and the inversion means comprises a mask holder for electrostatically sticking with an outer circumferential part of the stencil mask and a rotation means for rotating the mask holder about an axis of a supporting portion.

## Description

### BACKGROUND OF THE INVENTION

### 1. Field of the Invention

The present invention relates to a stencil mask on which an opening pattern for selectively letting charged particles pass to a substrate subjected to processing is formed by penetrating in the thickness direction, a charged particle irradiation apparatus using the stencil mask and the method, and particularly relates to a stencil mask wherein warps of the stencil mask is suppressed by not to disproportionate damaged regions irradiated by the charged particles on one surface of the stencil mask, a charged particle irradiation apparatus and the method.

### 2. Description of the Related Art

When producing a semiconductor device, ion implantation for implanting impurity ions to form a desired conductive type region on a substrate subjected to processing, such as a silicon substrate, has been performed. As a method of the ion implantation, there is a method of using a stencil mask arranged to face to the semiconductor substrate by leaving a predetermined distance. Refer to, for example, the Japanese Unexamined Patent Publication No. 11-288680 and "Outslicking in LSI Production System" in "Nikkei Microdevices" published by Nikkei Business Publications Inc., Feb. 2001, p. 45.

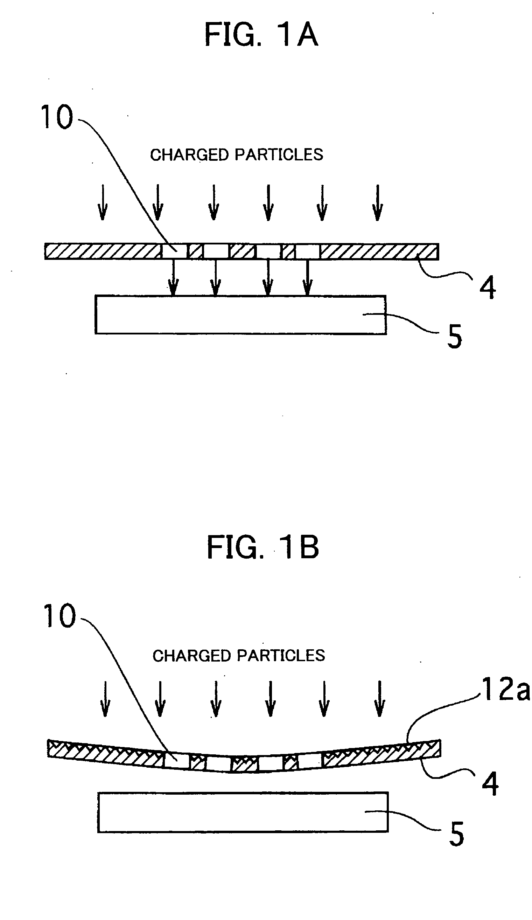

As shown in FIG. 1A, a stencil mask 4 is formed a desired opening pattern 10, and implantation of charged particles is selectively performed on a substrate 5 subjected to processing through the opening pattern 10.

Ion implantation using a stencil mask does not require a lithography step and a resist mask removal step as in a method of using a resist mask formed to be adhered to a semiconductor substrate, and one stencil mask can be repeatedly used. Accordingly, it is an efficient and low-cost process and is greatly expected as one of production techniques suitable to the high-mix low-volume production.

However, ion collision on regions other than the opening pattern is repeated when used repeatedly, and damages are accumulated on the regions. Consequently, after performing ion implantation process for a plurality of times, as shown in FIG. 1B, warps arise on the stencil mask 4 due to internal stress caused by a damaged layer 12a repeatedly affected by the ion collision, so that highly accurate ion implantation cannot be performed.

Thus, for example, in the "IEEE Transactions on Semiconductor Manufacturing", May 2002, vol. 15, No. 2, pp. 183 to 188 and "Technical Digest of International Electron Devices Meeting 2000 (IEDM2000)", pp. 869 to 871, a technique of heightening strength of a stencil mask by performing impurity implantation on the stencil mask in advance is disclosed.

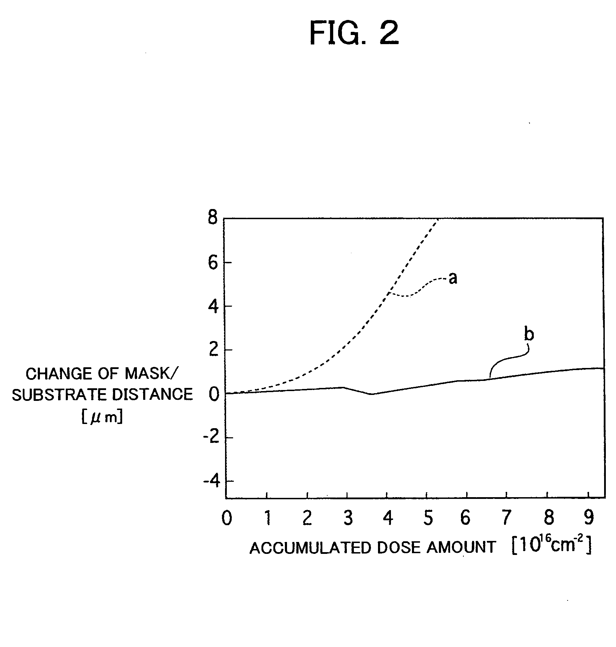

A graph in FIG. 2 shows a result of comparing amounts of warps of a stencil mask in the case of performing impurity implantation on the stencil mask in advance (a solid line "b") and that in the case of not performing the same (a dotted line "a"). An axis of abscissa indicates an ion accumulation dose amount, and an axis of ordinate indicates changes of a distance between the stencil mask and a substrate subjected to processing. As is obvious from FIG. 2, when performing impurity implantation on the stencil mask in advance (the solid line "b"), changes of the distance between the stencil mask and the substrate are small, that is, warps of the stencil mask can be suppressed.

However, to perform impurity implantation on the stencil mask in advance for suppressing warps separately from the ion implantation on the substrate subjected to processing takes troubles and time, which leads to an increase of the cost.

### SUMMARY OF THE INVENTION

An object of the present invention is to provide a stencil mask capable of attaining long durability without requiring special processing thereon, a charged particle irradiation apparatus and the method.

To attain the above object, according to the present invention, there is provided a stencil mask formed with an opening pattern penetrating in the thickness direction for selectively letting charged particles pass to a substrate subjected to processing, comprising a first opening pattern and a second opening pattern obtained by inverting the front and back of the first opening pattern as the opening pattern.

To attain the above object, according to the present invention, there is provided a charged particle irradiation apparatus, comprising a stencil mask formed with an opening pattern penetrating in the thickness direction, arranged to face a substrate subjected to processing; a charged particle irradiation means for irradiating charged particles to the stencil mask to irradiate the charged particles to the substrate subjected to processing through the opening pattern; and an inversion means for inverting the front and back of the stencil mask.

To attain the above object, according to the present invention, there is provided a charged particle irradiation method, comprising the steps of making one surface of a stencil mask formed with an opening pattern penetrating in the thickness direction face to a substrate subjected to processing, and irradiating charged particles from the other surface side of said stencil mask to irradiate the charged particles to the substrate subjected to processing through the opening pattern; inverting the front and back of the stencil mask, and making the other surface of the stencil mask face to the substrate subjected to processing; and irradiating the charged particles from the one surface side of said stencil mask to irradiate the charged particles to the substrate subjected to processing through the opening pattern.

As a result of inverting the front and back of the stencil mask, it is possible to exchange a surface receiving irradiation of charged particle with a surface facing to a substrate subjected to processing, so that it is prevented that only one surface of the stencil mask is disproportionately damaged by charged particles. Consequently, an internal stress caused by damages of the stencil mask becomes approximately equal on both surfaces of the stencil mask, the internal stresses generated on the respective surfaces cancel each other, and warps of the stencil mask can be suppressed. As a result, the number of times that the stencil mask can be repeatedly used (use durability) becomes large and the cost can be reduced.

As a material of the stencil mask, when considering contamination by floating particles caused by sputtering the stencil mask by charged particles, it is preferable that the same material as that of the substrate subjected to processing is used. For example, when the substrate is a silicone substrate, the stencil mask is made by a silicone material. Alternately, a metal material, such as tungsten hard to be sputtered may be used.

As the inversion means for inverting the stencil mask, the configuration of inverting the stencil mask together with the mask holder may be mentioned. For example, an inversion means provided with a mask holder for holding said stencil mask by sticking to an outer circumferential part of said stencil mask; and a rotation means for rotating said mask holder about an axis in parallel with a surface of said stencil mask.

As the configuration that the mask holder holds the stencil mask, an electrostatic chuck type for sticking to an outer circumferential part of one surface of the stencil mask and a clamp type for picking up outer circumferential part of both surfaces of the stencil mask may be applied.

Alternately, the mask holder may be inverted by a human hand without using the rotation means. The inversion means in this case is composed of a mask holder provided in a way capable of inverting. Note that when charged particle irradiation to the substrate is performed in vacuum, vacuum breaking of irradiation chamber has to be performed every time the mask holder is inverted and the production efficiency declines.

On the other hand, with the configuration of inverting the mask holder by a rotation means, such as an electric motor, the mask holder can be inverted by an operation from outside the irradiation chamber while maintaining a vacuum atmosphere of the irradiation chamber.

As an example of the configuration of the mask holder, the configuration comprising a ring-shaped sticking part for holding an outer circumferential part of the stencil mask and a supporting portion having a stick shape extending from the sticking part, for supporting the sticking part by the supporting portion from one side, and using the supporting portion as a rotation axis when rotating the mask holder to invert it, can be mentioned. Alternately, the configuration of comprising two supporting portions arranged at mutually opposing positions over the ring-shaped sticking part approximately in alignment, for supporting from both sides may be applied. When supported from one side, there is an advantage that a configuration for rotating and moving the mask holder can be simplified.

When the direction of an opening pattern changes due to inversion of the stencil mask, it is sufficient to form a first opening portion and a second opening portion obtained by inverting the front and back of the first opening pattern.

Furthermore, in this case, when provided with a shield member for selectively blocking either one of a path that said charged particles pass through said first opening pattern to reach to said substrate subjected to processing and a path that said charged particles pass through said second opening pattern to reach to said substrate subjected to processing every time the stencil mask is inverted, charged particle irradiation regions based only on either one of the first opening pattern and the second opening pattern can be formed. Namely, it is possible to prevent mixing of a charged particle irradiation region based on the first opening pattern and that based on the second opening pattern formed on one substrate subjected to processing. By providing the shield member between the stencil mask and the substrate, irradiation of charged particles to the stencil mask is not hindered by the shield member, so that a distribution on the damaged layer in the plane direction can be made equal on the front and back of the stencil mask.

As the timing of inverting the front and back of the stencil mask, the inversion can be less frequently performed in the case of inverting for every substrate subjected to processing or a plurality of substrates subjected to processing than in the case of inverting for every small region formed by dividing on the substrate subjected to processing. Thus, the production efficiency can be improved.

According to the present invention, by inverting the front and back of the stencil mask, positions can be changed, that is, a surface irradiated with charged particles can be on the side of facing to a substrate subjected to processing, and a surface faced to the substrate can be on the side of receiving irradiation of charged particles, so that it is possible to prevent only one surface of the stencil mask from disproportionately getting damaged by charged particles. Consequently, warps of the stencil mask due to damages of the stencil mask can be suppressed, as a result, the number of repeatedly using the stencil mask (use durability) can become large and the costs can be decreased.

### BRIEF DESCRIPTION OF DRAWINGS

These and other objects and features of the present invention will become clearer from the following description of the preferred embodiments given with reference to the attached drawings, in which:
FIG. 1A is a sectional view of a state where charged particles are irradiated on a substrate subjected to processing through an opening pattern of a stencil mask, and FIG. 1B is a sectional view of a state where warps arise on the stencil mask;
FIG. 2 is a graph showing the relationship of changes of a distance between the stencil mask and the substrate with an accumulation dose amount of charged particles;
FIG. 3 is a perspective view of a key part of a charged particle irradiation apparatus according to an embodiment of the present invention;
FIG. 4A and FIG. 4B are views showing irradiation of charged particles from one surface side of the stencil mask, wherein FIG. 4A is a perspective view and FIG. 4B is a sectional view;
FIG. 5 is a perspective view showing the state that the stencil mask is inverted together with mask holder;
FIG. 6A and FIG. 6B are views showing irradiation of charged particles when using a reversed stencil mask of that in FIG. 4A and FIG. 4B, wherein FIG. 6A is a perspective view and FIG. 6B is a sectional view;
FIG. 7A is a sectional view for explaining irradiation of charged particles from one surface side of a stencil mask held by a mask holder according to a third embodiment of the present invention, and FIG. 7B is a sectional view wherein the other surface side is a charged particle irradiation surface as a result that the stencil mask in FIG. 7A was reversed together with the mask holder;
FIG. 8 is a plan view showing a rectangular opening pattern formed on a stencil mask;
FIG. 9A is a plan view of an L-shaped opening pattern formed on a stencil mask, and FIG. 9B is a plan view of a state that the stencil mask in FIG. 9A is rotated about an axis indicated by a dashed line so that the front and back surfaces are inverted;
FIG. 10 is a plan view of a stencil mask according to a second embodiment of the present invention, wherein an opening pattern A and an opening pattern B obtained by inverting the front and back surfaces of the opening pattern A;
FIG. 11A is a sectional view of a state that a shield member according to a fourth embodiment of the present invention is provided between the stencil mask and the substrate to block charged particle irradiation through the opening pattern B, and FIG. 11B is a sectional view of a state where the stencil mask in FIG. 11A is inverted together with the mask holder, and the shield member blocks charged particle irradiation through the opening pattern A; and
FIG. 12 is a plan view of the shield member.

### DESCRIPTION OF THE PREFERRED EMBODIMENT

Below, the.present invention will be explained based on embodiments shown in drawings.

### First Embodiment

In the present embodiment, an ion implantation apparatus used for converting n-type and p-type conductive types and controlling impurity concentration in semiconductor crystal will be explained as an example of a charged particle irradiation apparatus.

### [Configuration of Charged Particle Irradiation Apparatus]

The ion implantation apparatus comprises an ion source, a weight analyzing unit, an acceleration unit, a deflection magnet and an irradiation unit, etc. In the ion source, atoms are ionized by discharging. In the weight analyzing unit, objective ions are taken out from an ion gas generated in the ion source, the acceleration unit accelerates the ions by using an electric field, and the deflection magnet deflects the accelerated ions to guide them to the irradiation unit.

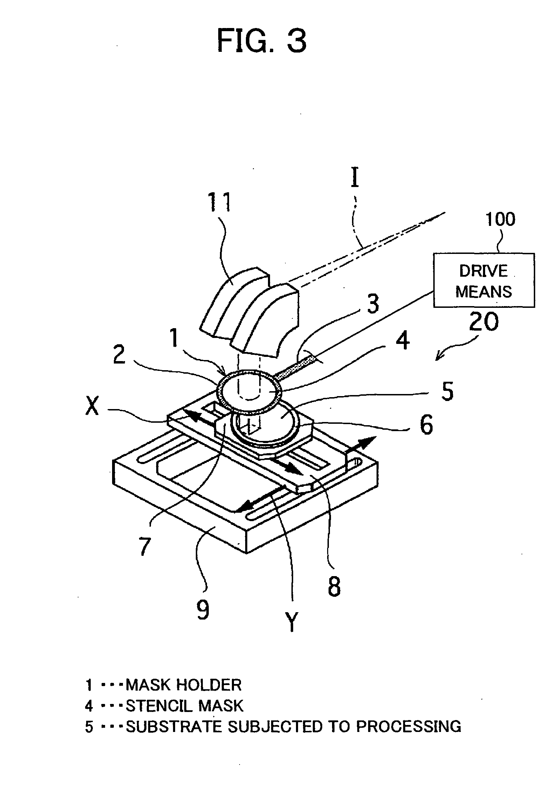

FIG. 3 is a perspective view of the deflection magnet 11 and the irradiation unit 20 provided below the deflection magnet 11. The irradiation unit 20 comprises a stage for supporting a substrate 5 subjected to processing and a mask holder 1 for holding a stencil mask 4 so as to face to the substrate 5.

The substrate 5 subjected to processing is, for example, a silicone substrate incorporating a large number of semiconductor chips, and the substrate 5 is supported by a stage 6. The stage 6 has, for example, a circular supporting surface and fixed on a first linearly moving stage 7. The first linearly moving stage 7 freely moves along an arrow X direction on a second linearly moving stage 8. The second linearly moving stage 8 freely moves along an arrow Y direction on a base 9. The moving direction (the arrow X) of the first linearly moving stage 7 and the moving direction (an arrow Y) of the second linearly moving stage 8 are at right angles to each other.

The stencil mask 4 is arranged to face to the substrate 5 by leaving a distance of, for example, several tens of µm to 100 µm. The stencil mask 4 is disk shaped and made, for example, by the same silicone material as that of the substrate 5. The substrate 5 and the stencil mask 4 face to each other in parallel.

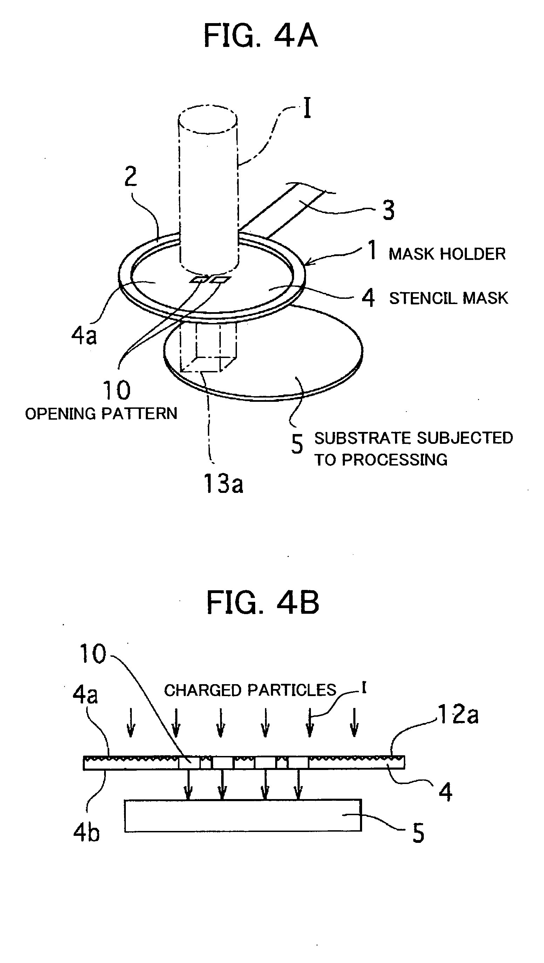

Also, the stencil mask 4 is formed with an opening pattern 10 as shown in FIG. 4A and FIG. 4B. The opening pattern 10 is formed as a set of a plurality of through holes penetrating the stencil mask 4 in the thickness direction.

The stencil mask 4 is held by the mask holder 1 by leaving the above distance from the substrate 5. The mask holder 1 has, for example, a ring-shaped electrostatic sticking part 2 configured by providing metal electrodes inside a ferroelectric ceramics, generates positive and negative charges between an outer circumferential part of the stencil mask 4 and the surface of the electrostatic sticking part 2 by applying a voltage to the metal electrode, and sticks to the outer circumferential part of the stencil mask 4.

The outer circumferential side of the electrostatic sticking part 2 of the mask holder 1 is connected to a stick-shaped supporting portion 3 extending out of the circumference, and the supporting portion 3 is connected to a mask holder drive means 100. The mask holder drive means 100 comprises a rotation means for inverting the mask holder 1, a vertical moving means for moving the mask holder 1 in the vertical direction, and a horizontal moving means for moving the mask holder 1 on a horizontal plane.

The rotation means is, for example, an electric motor, and the rotation means and the mask holder 1 compose an inverting means according to the present embodiment.

### [Charged Particle Irradiation Method on Substrate subjected to processing]

Next, a method of performing charged particle irradiation on a substrate subjected to processing by using the above charged particle irradiation apparatus will be explained.

First, as shown in FIG. 4A and FIG. 4B, in a state where one surface 4a of the stencil mask 4 faces to the side irradiated with the charged particles (the side facing to the deflection magnet 11 shown in FIG. 3), and the other surface 4b as an opposite surface of the surface 4a (refer to FIG. 4B) faces to the substrate 5, charged particles "I" are irradiated from the surface 4a side. The charged particles "I", for example, B ions, P ions and As ions, irradiate the stencil mask 4 as an accelerated charged particle beam having a unified direction.

The opening pattern 10 formed on the stencil mask 4 is aligned with a desired semiconductor chip 13a on the substrate 5 to be irradiated with the charged particles "I".

Only those which pass through the opening pattern 10 among the charged particles "I" irradiated on the stencil mask 4 are implanted to the semiconductor chip 13a, and a desired impurity region corresponding to the opening pattern 10 is formed on the semiconductor chip 13a. Other than the regions of the opening pattern 10, the charged particles "I" are implanted to the surface 4a of the stencil mask 4, collision of the charged particles "I" and crystal lattice atoms damages the crystal, and a damaged layer 12a is formed on the surface 4a (refer to FIG. 4B).

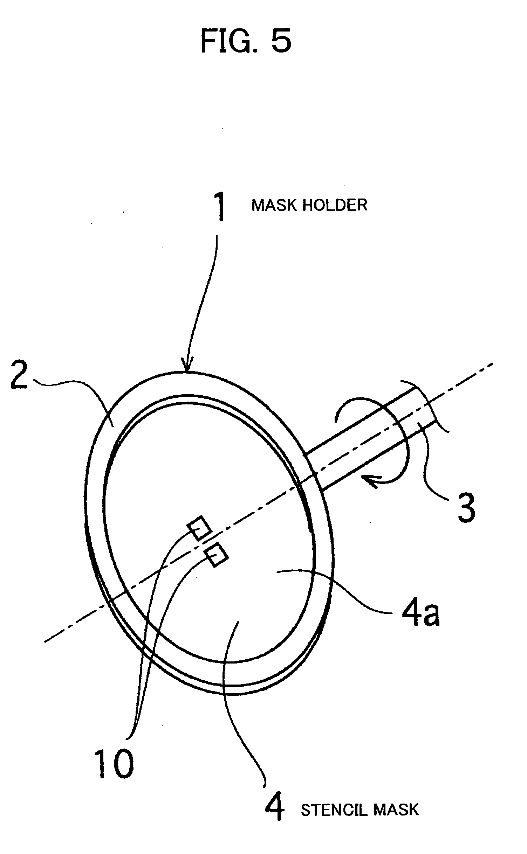

Next, when performing charged particle irradiation on other semiconductor chip, the stencil mask 4 is inverted as shown in FIG. 5 before that. Specifically, the rotation means (for example, an electric motor) connected to the supporting portion 3 of the mask holder 1 for holding the stencil mask 4 drives to rotate the mask holder 1 by using the supporting portion 3 as the rotation axis (using the axis in parallel with the surface of the stencil mask 4 indicated by a dashed line as the rotation axis). Due to the rotation of the mask holder 1, the stencil mask 4 whose outer circumferential part is stuck to the electrostatic sticking part 2 of the mask holder 1 also rotates to be inverted.

Note that when inverting the stencil mask 4 with the mask holder 1, the mask holder 1 is moved in the direction of receding from the stage by the vertical moving means explained above, inverted at the position, moved back to the stage side, and placed to approach to the substrate 5 by leaving a predetermined distance, so that interference with the substrate 5 or the stage for supporting the same can be prevented. Alternately, the mask holder 1 may be moved to a position away from the stage by the horizontal moving means explained above, inverted at the position and returned back to be above the stage.

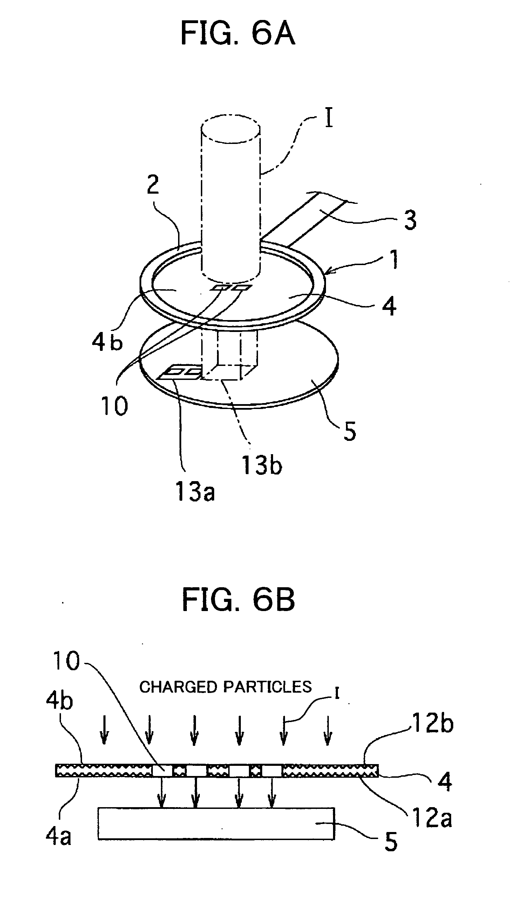

As a result of the above, as shown in FIG. 6A and FIG. 6B, the other surface 4b of the stencil mask 4 which faced to the substrate 5 at the time of charged particle irradiation to the previous semiconductor chip 13a was turned to face to the side of receiving irradiation of the charged particles "I" (the side facing to the deflecting magnet 11 shown in FIG. 3). Also, the surface 4a, which is an opposite surface of the surface 4b, faced to the side of receiving irradiation of charged particles "I" at the time of charged particle irradiation to the previous semiconductor chip 13a is made to face to the substrate 5.

Then, by moving the stages 6, 7 and 8 supporting the substrate 5 (refer to FIG. 3), etc., the opening pattern 10 formed on the stencil mask 4 is aligned with a semiconductor chip 13b to be irradiated by charged particles "I" this time (refer to FIG. 6A).

Also in this case, in the same way as the case of irradiating to the previous semiconductor chip 13a, the charged particles "I" are irradiated on the stencil mask 4 as an accelerated charged particle beam having a unified direction. Then, only charged particles passing through the opening pattern 10 are implanted to the semiconductor chip 13b, and a desired impurity region corresponding to the opening pattern 10 is formed on the semiconductor chip 13b.

Other than the regions of the opening pattern 10, the charged particles "I" are implanted to the surface 4b of the stencil mask 4, collision of the charged particles "I" and crystal lattice atoms of the stencil mask 4 damages the crystal, and a damaged layer 12b is formed on a superficial layer of the surface 4b (refer to FIG. 6B).

After that, on other semiconductor chips on the substrate 5, the charged particle irradiation is performed by inverting the front and back of the stencil mask 4 for each semiconductor chip or for a plurality of semiconductor chips.

Accordingly, the degree of damaging the crystal (the damaged layers 12a and 12b) is not disproportionated to one surface but becomes even on the front and back surfaces 4a and 4b of the stencil mask 4, so that a stress caused by the crystal damage is evenly distributed to the front and back. As a result, arising of warps of the stencil mask 4 can be suppressed and the stencil mask 4 can be made durable. Also, by performing annealing processing by heating on the stencil mask 4 by using, for example, an electric furnace or laser after forming the damaged layers 12a and 12b, warps can be furthermore effectively prevented.

Note that the timing of inverting the front and back of the stencil mask 4 is not limited to a unit of a semiconductor chip, and the stencil mask 4 may be inverted for every substrate 5 subjected to the processing or every lot (every certain number of substrates 5). Effective semiconductor production can be attained in the latter cases than the case of inverting in unit of a semiconductor chip because frequency of inverting the stencil mask 4 can be reduced.

As shown in FIG. 2, with a dose amount of 1×10¹⁶ cm⁻ ², an amount of warps of the stencil mask is not large enough to affect ion implantation. For example, an ion implantation dose amount for forming a well or channel stop, etc. on a MOS transistor is 10¹³ cm⁻² or so, and when assuming to form 100 semiconductor chips per one substrate subjected to processing, the accumulation dose amount becomes only 10¹³ cm-² × 100 = 10¹⁵ cm⁻². Therefore, balance of stresses can be sufficiently maintained between the front and back of the stencil mask even when inverting for every substrate or every lot, and arising of warps can be prevented.

### Second Embodiment

Next, a second embodiment of the present invention will be explained. Note that the same reference numbers are given to components having the same configuration as those in the above first embodiment and a detailed explanation thereof will be omitted.

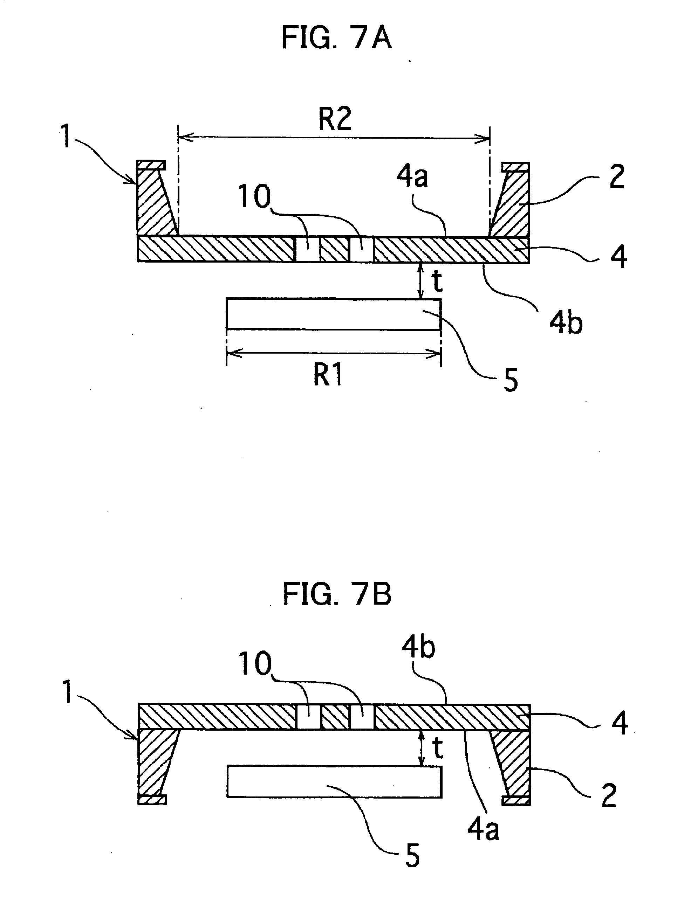

The characteristic of the present embodiment is, as shown in FIG. 7A, that an inner diameter R2 of the electrostatic sticking part 2 for sticking to the outer circumference of the surface 4a of the stencil mask 4 is made larger than a diameter R1 of the substrate 5 subjected to processing in the mask holder 1. It is, for example, R2 ≥ 2 × R1. Of course, the electrostatic sticking part 2 does not overlap the opening pattern 10, and irradiation of charged particles to the substrate 5 through the opening pattern 10 is not hindered by the mask holder 1.

Also in the present embodiment, in the same way as in the above first embodiment, as shown in FIG. 7A, in a state where the surface 4a of the stencil mask 4 is made to face to the charged particle irradiation side, and the other surface 4b as an opposite surface of the surface 4a is made to face to the substrate 5, charged particles are irradiated from the surface 4a side first. A distance "t" between the surface 4b of the stencil mask 4 and the substrate 5 is made to be, for example, several tens of µm to 100 µm or so.

Only those passing through the opening pattern 10 among charged particles to be irradiated on the stencil mask 4 are implanted to a semiconductor chip on the substrate 5. Other than the regions of the opening pattern 10, charged particles are implanted on the surface 4a of the stencil mask 4, and a superficial layer of the surface 4a is damaged by collision of the charged particles and crystal lattice atoms of the stencil mask 4.

Next, when performing charged particle irradiation on other semiconductor chip, in the same way as in the first embodiment, the stencil mask 4 is inverted together with the mask holder 1 for holding the stencil mask 4. When inverting, the mask holder 1 is moved in the direction of receding from the stage by a vertical moving means explained above, inverted at the position, moved back to above the stage, and made to be close to the substrate 5 by leaving a desired distance "t", so that interference with the substrate 5 or the stage for supporting the same can be prevented. Alternately, the mask holder 1 may be moved by the horizontal moving means explained above to be away from the stage, inverted at the position and returned to above the stage.

Consequently, as shown in FIG. 7B, the surface 4b of the stencil mask 4 faced to the substrate 5 when performing charged particle irradiation to the previous semiconductor chip was made to face to the side of receiving irradiation of charged particles. The surface 4a, being an opposite surface of the surface 4b, which faced to the charged particle irradiation side at the time of performing charged particle irradiation on the previous semiconductor chip is made to face to the substrate 5.

At this time, by making the inner diameter R2 of the electrostatic sticking part 2 of the mask holder 1 larger than the diameter R1 of the substrate 5, even when the stencil mask 4 is inverted and the electrostatic pick up part 2 moves to the side of facing to the substrate, as shown in FIG. 7B, interference between the electrostatic sticking part 2 and the substrate can be prevented. Accordingly, the distance "t" between the surface 4a of the stencil mask 4 facing to the substrate 5 and the substrate 5 can be also maintained after the inversion.

The distance "t" between the stencil mask 4 and the substrate 5 has to be as close as several tens of µm to 100 µm or so for securing desired irradiation accuracy, and highly accurate charged particle irradiation can be performed under a condition of maintaining the close distance before and after inverting the stencil mask 4 without being hindered by the mask holder 1 in the present embodiment. Note that in the above example, the electrostatic sticking part 2 was made to stick to the outer circumferential part of the surface 4a of the stencil mask 4, but it may be made to stick to the outer circumferential part of the surface 4b.

### Third Embodiment

Next, a third embodiment of the present invention will be explained. Note that the same reference numbers are given to the same components as those in the above first and second embodiments and a detailed explanation thereof will be omitted.

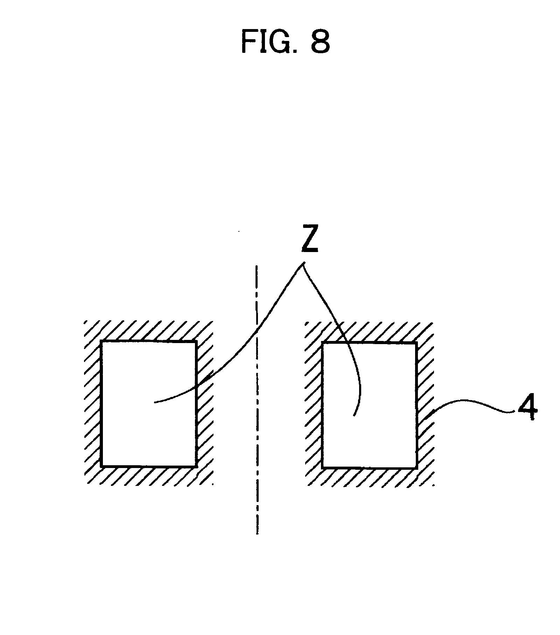

As an opening pattern to be formed on the stencil mask 4, for example shown in FIG. 8, in the case of an opening pattern "Z" wherein same rectangular shaped opening portions are formed across a rotation axis indicated by a dashed line, even when the stencil mask 4 is rotated about the rotation axis to be inverted, the same opening pattern "Z" is obtained before and after the inversion.

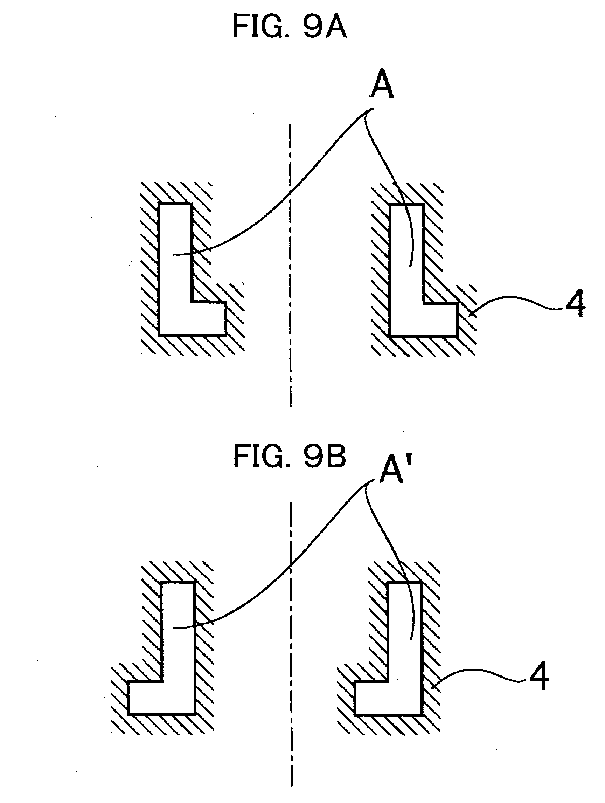

As shown in FIG. 9A, however, for example, in the case of an opening pattern "A" made by forming same L-shaped openings across the rotation axis indicated by the dashed line, when the stencil mask 4 is rotated about the rotation axis to be inverted, as shown in FIG. 9B, an opening pattern "A"' is obtained wherein the direction of the L-shaped opening portion becomes opposite from side to side from that of the opening pattern "A".

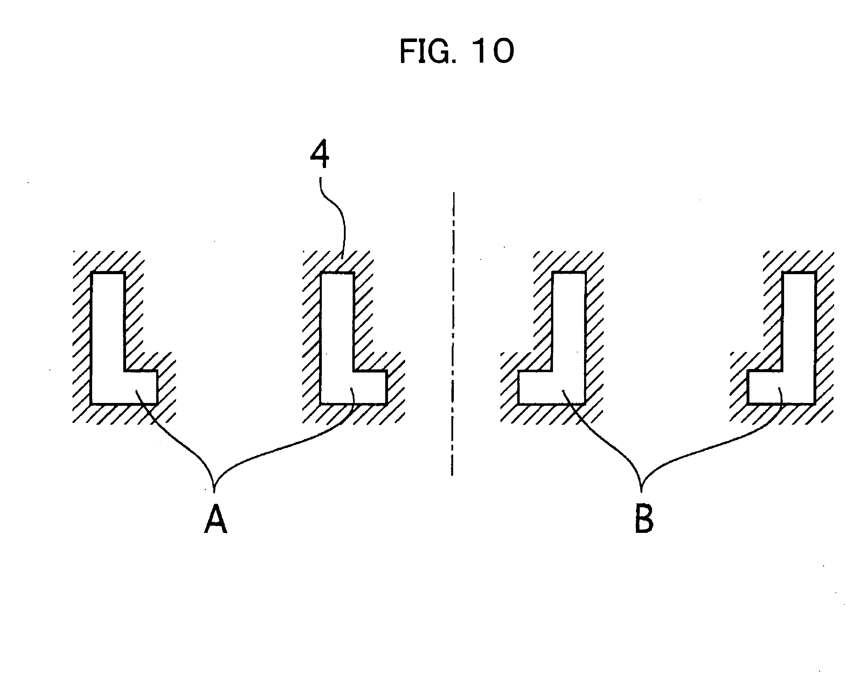

In this case, as shown in FIG. 10, in addition to the opening pattern (first opening pattern) A, an opening pattern (second opening pattern) B obtained by inverting the opening pattern A from side to side is formed so as to be symmetrical to each other across the rotation axis of the stencil mask 4 (indicated by dashed line). Namely, two opening patterns A and B symmetrical to each other about the rotation axis are formed on the same stencil mask 4. When the stencil mask 4 is rotated about the rotation axis to invert the front and back, the opening pattern A is converted to be in the direction of the opening pattern B, and the opening pattern B is converted to be in the direction of the opening pattern A.

By using the stencil mask 4 having opening patterns A and B as above, charged particle irradiation is performed, for example, on two adjacent semiconductor chips formed on the substrate 5 at a time. One of the semiconductor chips is subjected to charged particle irradiation through the opening pattern A, and the other semiconductor chip adjacent to that is subjected to charged particle irradiation through the opening pattern B.

When the irradiation is finished, the stencil mask 4 is inverted and charged particle irradiation is performed on two semiconductor chips through the opening patterns A and B in the same way. After the irradiation, the stencil mask 4 is again inverted and charged particle irradiation is performed on still other two chips. After that, by repeating the process, devices can be effectively produced. Note that the timing of inverting the stencil mask 4 is again not limited to the unit of a semiconductor chip and the stencil mask 4 may be inverted for every substrate subjected to the processing or every lot.

According to the present embodiment, one semiconductor chip is formed with a charged particle implantation region (impurity implantation region) corresponding to the opening pattern A, and the other semiconductor chip is formed with a charged particle implantation region corresponding to the opening pattern B on one substrate subjected to processing, and the respective semiconductor chips exhibit good performance.

### Fourth Embodiment

Next, a fourth embodiment of the present invention will be explained. Note that the same components as those in the above first, second and third embodiments are given the same reference numbers and a detailed explanation thereof will be omitted.

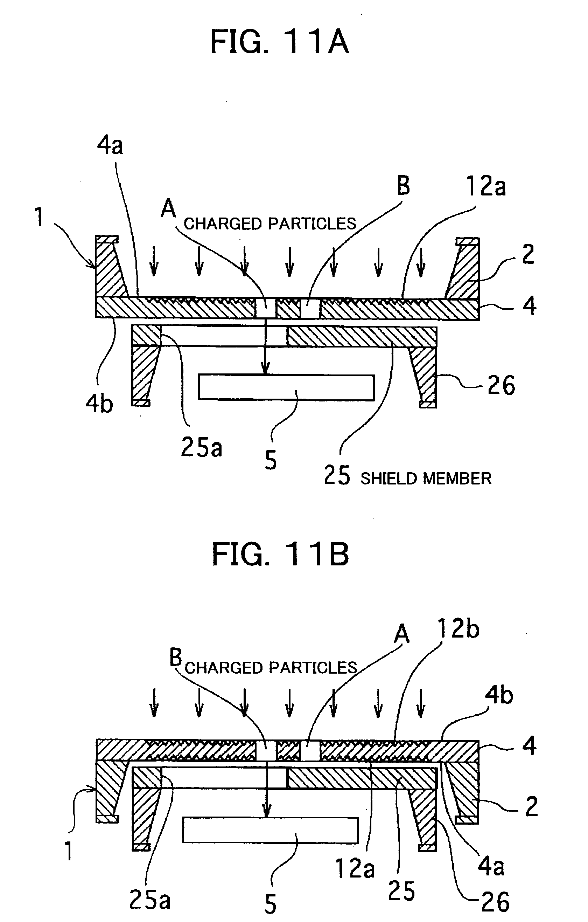

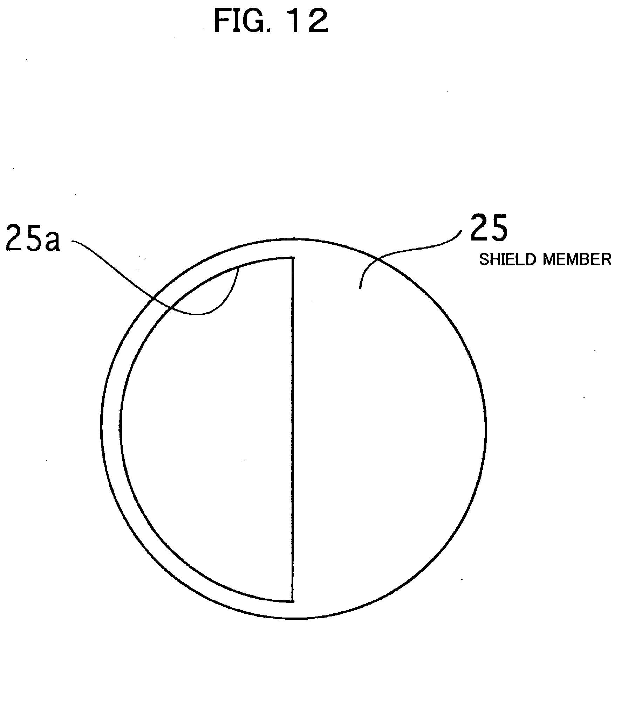

In the present embodiment, as shown in FIG. 11A, a shield member 25 is provided between the stencil mask 4 and the substrate 5 subjected to processing. The shield member 25 is made by the same material as that of the substrate 5, for example a silicone material, and disk shaped as shown in FIG. 12, wherein about a half of the region is cut out in a semicircular shape to form an opening portion 25a.

The shield member 25 is supported by an electrostatic chuck 26 for sticking to an outer circumferential part of a surface facing to the substrate 5. An inner diameter of the electrostatic chuck 26 is larger than the diameter of the substrate 5, so that the substrate 5 is not interfered.

A depth of implanting charged particles (ions) is several µm at most in producing a semiconductor, so that 10 µm or so is sufficient as a thickness of the shield member 25 serving for partially blocking permeation of charged particles. Therefore, it is possible to provide the shield member 25 in the space (several tens of µm to 100 µm) between the stencil mask 4 and the substrate 5.

In the present embodiment, first, as shown in FIG. 11A, a not cut-out region of the shield member 25 is placed below the opening pattern B explained in the above third embodiment and the opening portion 25a of the shield member 25 is placed below the opening pattern A.

Consequently, charged particles passed through the opening pattern B are implanted to the shield member 25 and do not reach the substrate 5. On the other hand, charged particles passed through the opening pattern A pass through the opening portion 25a and implanted to the semiconductor chip on the substrate 5.

Next, in the same way as in the above embodiments, the front and back of the stencil mask 4 are inverted together with the mask holder 1. As shown in FIG. 11B, being inversed from the previous case, the opening pattern A is placed at the not cut-out portion of the shield member 25 and the opening pattern B is placed at the opening portion 25a of the shield member 25.

Consequently, charged particles passed through the opening pattern A are implanted to the shield member 25 and do not reach the substrate 5, while charged particles passed through the opening pattern B pass through the opening portion 25a and implanted to the semiconductor chip on the substrate 5.

At this time, as explained in the third embodiment, an inverted opening pattern B becomes to be in the same direction as the opening pattern A, so that a charged particle irradiation region (impurity implantation region) corresponding to the opening pattern A is formed on a semiconductor chip on the substrate both in the case before the inversion shown in FIG. 11A and in the case after the inversion shown in FIG. 11B.

As a result, unnecessary increase of costs can be prevented through out the whole production steps of semiconductor devices. Specifically, when different impurity implantation regions based on the two opening patterns A and B are formed in the charged particle irradiation step, those having a different pattern have to be prepared even for masks used in other steps, such as etching, for conforming to the opening patterns A and B, which leads to a large increase of the costs. Furthermore, there are two or more standards for those produced basically as same products, and the costs also including designing costs are largely increased.

On the other hand, in the present embodiment, by using the shield member 25 as above, impurity implantation regions based on the same opening pattern can be always formed even when repeatedly inverting the front and back of the stencil mask 4, and the cost increase as above is not brought.

Note that a damaged layer implanted with charged particles is also formed on the shield member 25. However, in the shield member 25, it is not necessary to consider alignment accuracy with respect to the semiconductor chip. Also, charged particles to be implanted are only those passed through an opening pattern of the stencil mask 4, and a dose amount of the incident charged particles is far less than that on the stencil mask 4. Furthermore, about a half of the region is cut out. Accordingly, warps hardly arise.

As explained above, each embodiment of the present invention was explained, but the present invention is not limited to that and can be variously modified based on technical thoughts of the present invention.

A charged particle irradiation apparatus may be any apparatus as far as it is an apparatus for selectively irradiating charged particles to a substrate subjected to processing by using a stencil mask formed with an opening pattern. It is not limited to an ion implantation apparatus, and an ion etching apparatus, a plasma etching apparatus and an electron beam exposure apparatus, etc. may be mentioned.

Also, as a substrate subjected to processing, semiconductor substrates of silicon, germanium and gallium arsenic, etc., a liquid crystal panel substrate, and other substrates subjected to processing of being irradiated with charged particles may be mentioned.

The embodiments explained above are for easier understanding of the present invention and not to limit the present invention. Accordingly, respective elements disclosed in the above embodiments includes all modifications in designs and equivalents belonging to the technical field of the present invention.

## Claims

1. A stencil mask formed with an opening pattern penetrating in the thickness direction for selectively letting charged particles pass to a substrate subjected to processing, comprising
a first opening pattern and a second opening pattern obtained by inverting the front and back of said first opening pattern as said opening pattern.

2. A charged particle irradiation apparatus, comprising:
a stencil mask formed with an opening pattern penetrating in the thickness direction, arranged to face a substrate subjected to processing;
a charged particle irradiation means for irradiating charged particles to said stencil mask to irradiate said charged particles to said substrate subjected to processing through said opening pattern; and
an inversion means for inverting the front and back of said stencil mask.

3. A charged particle irradiation apparatus as set forth in claim 2, wherein
said inversion means comprises
a mask holder for holding said stencil mask by sticking to an outer circumferential part of said stencil mask; and
a rotation means for rotating said mask holder about an axis in parallel with a surface of said stencil mask.

4. A charged particle irradiation apparatus as set forth in claim 3, wherein an inner diameter at a part sticking to the outer circumference of said stencil mask is larger in said mask holder than a size of a plane of said substrate subjected to processing.

5. A charged particle irradiation apparatus as set forth in claim 2, wherein said stencil mask has, as said opening pattern, a first opening pattern and a second opening pattern obtained by inverting the front and back of said first opening pattern.

6. A charged particle irradiation apparatus as set forth in claim 5, further comprising a shield member for selectively blocking either one of a path that said charged particles pass through said first opening pattern to reach to said substrate subjected to processing and a path that said charged particles pass through said second opening pattern to reach to said substrate subjected to processing.

7. A charged particle irradiation method, comprising the steps of:
making one surface of a stencil mask formed with an opening pattern penetrating in the thickness direction face to a substrate subjected to processing, and irradiating charged particles from the other surface side of said stencil mask to irradiate said charged particles to said substrate subjected to processing through said opening pattern;
inverting the front and back of said stencil mask, and making the other surface of said stencil mask face to said substrate subjected to processing; and
irradiating said charged particles from said one surface side of said stencil mask to irradiate said charged particles to said substrate subjected to processing through said opening pattern.

8. A charged particle irradiation method as set forth in claim 7, wherein inversion of the front and back of said stencil mask is performed for every said substrate subjected to processing or a plurality of said substrate subjected to processing.
